# EUROPÄISCHE PATENTSCHRIFT

(11) **EP 3 799 549 B1**
(45) Veröffentlichungstag und Bekanntmachung des Hinweises auf die Patenterteilung: **05.10.2022**
(21) Anmeldenummer: 20190649.2
(22) Anmeldetag: 12.08.2020
(51) Int. Cl.: H01L 23/36, H05K 7/20, H01L 23/40

(54) **HALTEVORRICHTUNG ZUR THERMISCHEN KONTAKTIERUNG EINES AUF EINER LEITERPLATTE MONTIERTEN ELEKTRONISCHEN BAUTEILS MIT EINEM KÜHLKÖRPER**
HOLDING DEVICE FOR THERMALLY CONTACTING AN ELECTRONIC COMPONENT MOUNTED ON A CIRCUIT BOARD WITH A HEAT SINK
DISPOSITIF DE MAINTIEN DESTINÉ AU CONTACT THERMIQUE D'UN COMPOSANT ÉLECTRONIQUE MONTÉ SUR UNE CARTE DE CIRCUIT IMPRIMÉ AVEC UN DISSIPATEUR THERMIQUE

(30) Priorität: 22.08.2019 DE 102019122640
(43) Veröffentlichungstag der Anmeldung: 31.03.2021
(60) Teilanmeldung: 21199737.4
(73) Patentinhaber: ebm-papst Mulfingen GmbH & Co. KG, 74673 Mulfingen (DE)
(72) Erfinder: Holderbach, Christoph, 74722 Buchen (DE); Lust, Alexander, 74182 Obersulm (DE); Hirschlein, Nico, 97980 Bad Mergentheim-Rengershausen (DE)
(74) Vertreter: Staeger & Sperling Partnerschaftsgesellschaft mbB

(56) Entgegenhaltungen:
- US-A1- 2010 226 096
- US-A1- 2018 343 775
- US-B2- 9 147 634

## Beschreibung

Die Erfindung betrifft eine Haltevorrichtung zur thermischen Kontaktierung eines auf einer Leiterplatte montierten elektronischen Bauteils mit einem Kühlkörper.

Bei elektronischen Bauteilen und insbesondere bei Leitungselektronik-Bauteilen, welche auf einer Leiterplatte montiert sind und im Betrieb Wärme erzeugen und abgeben, ist es in der Regel notwendig, die Wärme von den Bauteilen abzuführen. Hierzu werden diese meist mit einem Kühlkörper verbunden.

Sind die Kühlkörper groß bzw. schwer oder integral mit einem Gehäuse ausgebildet, welches die Leiterplatte und das elektronische Bauteil aufnimmt, ist oftmals vorgesehen, die elektronischen Bauteile erst bei der Montage der Leiterplatte in dem die Leiterplatte aufnehmenden Gehäuse thermisch mit dem Kühlkörper zu verbinden.

Zur Anbindung der elektronischen Bauteile sind im Stand der Technik meist mehrere voneinander getrennte Komponenten notwendig. Beispielsweise umfassen solche Systeme ein Wärmeleitpad, welches zwischen dem Bauteil und dem Kühlkörper angeordnet werden muss, und ein Klemmelement, welches das Bauteil nach der Montage des Wärmeleitpads gegen dieses und den Kühlkörper presst.

Die bekannten Lösungen haben jedoch meist mehrere Nachteile. Zunächst müssen das Wärmeleitpad und das Klemmelement in zwei aufeinanderfolgenden Schritten in dem Gehäuse bzw. an dem Kühlkörper vormontiert werden. Anschließend wird die Leiterplatte, welche auch als Platine bezeichnet werden kann, in das Gehäuse eingelegt und das Klemmelement endmontiert, wodurch das elektronische Bauteil von dem Klemmelement gegen das Wärmeleitpad und den Kühlkörper gepresst wird.

Dabei ist jedoch problematisch, dass es dazu kommen kann, dass durch die zwei getrennten Montageschritte die Montage des Wärmeleitpads vergessen wird. Da der Einbaubereich des Wärmeleitpads anschließend oftmals von der Leiterplatte überdeckt wird, kann ein solcher Fehler leicht übersehen werden. Eine optische Überwachung zur Detektion des Fehlers ist zwar möglich, jedoch aufwändig und teuer.

Abgesehen davon, kann neben dem vollständigen Fehlen des Wärmeleitpads auch nicht kontrolliert werden, ob das Bauteil vollflächig an dem Wärmeleitpad anliegt oder ob es durch eine fehlerhafte Montage zwischen Wärmeleitpad und Bauteil zu Lufteinschlüssen oder Verwerfungen bzw. Verschiebungen des Wärmeleitpads kommt, so dass das Bauteil mit einer vorgesehenen Fläche nicht vollständig an dem Wärmeleitpad anliegt. Da es auch erst während der Montage des Bauteils auf dem Wärmeleitpad zu den Verwerfungen oder Verschiebungen kommen kann, sind solche Fehler auch durch eine optische Überwachung nicht oder kaum detektierbar.

Da es sich zudem bei den Wärmeleitpads für gewöhnlich um Standardbauteile handelt und die zueinander gewandten und korrespondierenden Flächen von elektronischem Bauteil und Kühlkörper nicht zwingend zueinander parallel sind, kann durch die bekannten Lösungen ein Versatz oder ein Winkel zwischen den Flächen meist nicht ausgeglichen werden.

Ohne das Wärmeleitpad oder für den Fall, dass das elektronische Bauteil nicht vollflächig an dem Wärmeleitpad anliegt, wird die Wärme jedoch meist nur unzureichend von dem elektronischen Bauteil auf den Kühlkörper abgeführt, wodurch es im Betrieb zu einer Beschädigung des Bauteils kommen kann.

Eine optische Überwachung zur Vermeidung solcher Fehler ist aufgrund dessen, das die Leiterplatte den Kühlkörper und das Wärmeleitpad meist überdeckt, nicht bzw. nur sehr aufwändig und kostenintensiv möglich.

Zum anderen kann die Montagereihenfolge sich negativ auf den Entwärmungsprozess auswirken, da das Klemmelement im Stand der Technik zeitlich meist nach der Leiterplatte in dem Gehäuse endmontiert wird. Somit ist das Leistungsmodul bzw. das elektronische Bauteil an seiner Pinseite bereits an der Leiterplatte fixiert und die Auslenkungsweite des Bauteils bzw. ein Auslenkwinkel, um welchen das Bauteil zu dem Wärmeleitpad hin ausgelenkt bzw. gekippt werden muss, beinhaltet alle auftretenden Toleranzen, welche bei der Montage der Leiterplatte auftreten können.

Der Auslenkungswinkel des elektronischen Bauteils ist durch den Montageprozess sowie die oftmals herstellungsbedingte Entformungsschräge des Gehäuses bzw. des Kühlkörpers in entgegengesetzte Richtungen angeordnet, wodurch keine parallele Anbindung der Oberflächen des elektronischen Bauteils an das Elektronikgehäuse bzw. den Kühlkörper möglich ist, so dass es wiederum zu einem Luftspalt bzw. zu Lufteinschlüssen zwischen dem elektronischen Bauteil und dem Kühlkörper kommen kann.

Druckschriftlicher Stand der Technik im vorliegenden technischen Gebiet ist in den Dokumenten US 2018/343775 A1, US 2010/226096 A1 und US 9,147,634 B2 offenbart.

Der Erfindung liegt deshalb die Aufgabe zugrunde, die vorgenannten Nachteile zu überwinden und eine Haltevorrichtung zur thermischen Kontaktierung eines auf einer Leiterplatte montierten elektronischen Bauteils mit einem Kühlkörper bereitzustellen, durch welche die thermische Kontaktierung kostengünstig und zugleich prozesssicher hergestellt werden kann.

Diese Aufgabe wird durch die Merkmalskombination gemäß Patentanspruch 1 gelöst.

Erfindungsgemäß wird eine Haltevorrichtung zur thermischen Kontaktierung eines auf einer Leiterplatte montierten elektronischen Bauteils mit einem Kühlkörper vorgeschlagen, wobei die Haltevorrichtung einen Haltekörper, ein Federelement und ein Spannelement aufweist. Der Haltekörper bildet einen zu dem elektronischen Bauteil korrespondierenden Hohlraum zur Aufnahme des elektronischen Bauteils aus und weist einen Anbindungsabschnitt sowie einen an den Hohlraum angrenzenden und thermisch leitenden Wärmeleitabschnitt auf. Der Wärmeleitabschnitt verfügt über eine von dem Hohlraum abgewandte thermischen Anbindungsfläche, welche vorzugsweise ausgebildet ist, in einem endmontierten Zustand vollflächig an dem Kühlkörper anzuliegen, so dass der Wärmeleitabschnitt an seiner zu dem Hohlraum gewandten Seite insbesondere vollflächig an dem elektronischen Bauteil und an der thermischen Anbindungsfläche an dem Kühlkörper anliegt und diese thermisch verbindet. Das Spannelement ist zudem ausgebildet, das Federelement zu spannen, wobei das Federelement ausgebildet ist, sich in einem gespannten Zustand an einem Gegenhalteelement abzustützen und eine Kraft auf den Haltekörper und/oder das in dem Hohlraum des Haltekörpers aufnehmbare Bauteil auszuüben und den Haltekörper mit der Anbindungsfläche vorzugsweise im Wesentlichen orthogonal zu der Anbindungsfläche an den Kühlkörper zu verschieben und/oder gegen den Kühlkörper zu pressen.

Abhängig von der jeweiligen Ausführungsform kann die Haltevorrichtung das Gegenhalteelement umfassen, wobei vorzugsweise vorgesehen ist, dass das Gegenhalteelement gegenüber der Leiterplatte und/oder dem Kühlkörper im Wesentlichen ortsfest ist. Alternativ kann das Gegenhalteelement jedoch auch integral mit dem Kühlkörper oder beispielsweise auch der Leiterplatte ausgebildet sein.

Bei dem elektronischen Bauteil handelt es sich vorzugsweise um elektronische Bauteile, welche mit einem "Single In-Line Package" (SIP) bzw. zu Deutsch mit einem einreihigen Gehäuse ausgebildet sind, welche also ein einzelne Pin- bzw. Kontaktstift-Reihe besitzen, mit welchen sie auf der Leiterplatte kontaktierbar sind. Insbesondere kann es sich bei solchen Bauteilen um Leistungsmodule zur Umformung elektrischer Energie handeln, welche sich im Betrieb erhitzen, so dass die Wärme zur Vermeidung von Schäden an dem Bauteil selbst und einer umliegenden Elektronik abgeführt werden muss. Als elektronisches Bauteil zur Aufnahme in der Haltevorrichtung kommt darüber hinaus jedoch auch eine andere ein Gehäuse aufweisende Elektronik in Betracht, welche sich im Betrieb erhitzt und gekühlt bzw. an einen Kühlkörper angebunden werden muss. Beispielsweise können durch die Haltevorrichtung auch Gehäuse der Bauform TO-220 aufgenommen werden, wobei die Haltevorrichtung bzw. der Hohlraum des Haltekörpers zu dem jeweiligen elektronischen Bauteil korrespondierend ausgebildet sein muss.

Ist an dem elektronischen Bauteil eine Wärmeableitfläche vorgesehen, ist der Haltekörper vorzugsweise so ausgebildet, dass das Bauteil mit der Wärmeableitfläche zu dem Wärmeleitabschnitt weisend und an diesem anliegend in dem Hohlraum aufgenommen werden kann.

Vorzugsweise wird die vorgeschlagene Haltevorrichtung zur thermischen Kontaktierung eines elektronischen Bauteils einer Motorsteuerung mit einem Kühlkörper verwendet, wobei die Motorsteuerung in einem Gehäuse oder Gehäusedeckel eines Elektromotors angeordnet ist und wobei das Gehäuse oder der Gehäusedeckel Kühlrippen aufweist und integral als der Kühlkörper ausgebildet ist. Darüber hinaus treibt der Elektromotor vorzugsweise einen Ventilator oder Lüfter an oder ist integral als ein solcher ausgebildet.

Die Erfindung sieht vor, dass der Anbindungsabschnitt bei den bei der bestimmungsgemäßen Verwendung der Haltevorrichtung herrschenden Temperaturen formfest und aus einem Thermoplast ausgebildet ist. Der Wärmeleitabschnitt ist zudem aus einem wärmeleitfähigen thermoplastischen Elastomer gebildet. Der Anbindungsabschnitt kann somit als Hartkomponente und der Wärmeleitabschnitt als Weichkomponente des Haltekörpers bezeichnet werden. Die Weichkomponente kann sich durch die Wärmeeinwirkung des elektronischen Bauteils verformen und sowohl an das elektronische Bauteil als auch an den angrenzenden Bereich des Kühlkörpers anpassen und durch eine plastische Verformung formschlüssig anliegen sowie eventuelle Lufteinschlüsse verdrängen.

Vorzugsweise ist der Haltekörper zudem einstückig ausgebildet und insbesondere der Anbindungsabschnitt stoffschlüssig mit dem Wärmeleitabschnitt verbunden. Hierzu kann der Haltekörper beispielsweise in einem Mehrkomponenten-Spritzgussverfahren bzw. hier in einem Zweikomponenten-Spritzgussverfahren hergestellt werden, wobei die Hartkomponente wie beschrieben aus einem Thermoplast und die Weichkomponente aus einem thermoplastischen Elastomer ausgebildet werden kann.

Darüber hinaus ist bei einer ebenfalls vorteilhaften Ausgestaltung der erfindungsgemäßen Haltevorrichtung vorgesehen, dass eine den Hohlraum umgebende Wandung von dem Anbindungsabschnitt und dem Wärmeleitabschnitt gebildet wird.

Dabei ist jedoch die Wandung bei einer vorteilhaften Weiterbildung in mehrere Wandungsabschnitte geteilt, wobei vorzugsweise einer Seite des elektronischen Bauteils ein Wandungsabschnitt zugeordnet ist und ein Wandungsabschnitt durch den Anbindungsabschnitt oder den Anbindungsabschnitt und den Wärmeleitabschnitt gebildet wird. Darüber hinaus liegen die Wandungsabschnitte vorzugsweise jeweils zumindest teilweise an dem elektronischen Bauteil an, so dass dieses von jeweils gegenüberliegenden Wandungsabschnitten ortsfest in dem Hohlraum gehalten ist.

Zudem umließt der Anbindungsabschnitt den Wärmeleitabschnitt in einer Variante, welche von Vorteil ist, rahmenförmig.

Zum Anordnen des elektronischen Bauteils in die Haltevorrichtung bzw. in den Hohlraum des Haltekörpers weist der Haltekörper eine mit dem Hohlraum verbundene Öffnung auf, durch welche das elektronische Bauteil in den Hohlraum einsteckbar ist. Die Öffnung ist dabei der Leiterplatte, auf welcher das elektronische Bauteil montiert ist, zugewandt.

Eine vorteilhafte Variante sieht daher vor, dass der Haltekörper fünf Wandungsabschnitte aufweist, welche jeweils an den Hohlraum bzw. ein darin aufnehmbares elektronisches Bauteil angrenzen, sowie eine Öffnung, welche einen sechsten Wandungsabschnitt ersetzt, so dass der Hohlraum des Haltekörpers von den fünf Wandungsabschnitten und der Öffnung bestimmt ist. Zudem kann sich der Wärmeleitabschnitt über einen oder mehrere Wandungsabschnitte erstrecken, wobei der Wärmeleitabschnitt von dem Anbindungsabschnitt eingerahmt wird.

Ein dem Kühlkörper zugewander Abschnitt der Wandung kann zudem in einem Querschnitt keilförmig ausgebildet sein, so dass ein Winkelversatz zwischen einer im Wesentlichen vertikal verlaufenden, dem Wärmeleitabschnitt zugwandten Fläche des elektronischen Bauteils und einer dazu schräg verlaufenden Fläche des Kühlkörpers, welcher die Anbindungsfläche zugewandt ist, ausgeglichen werden kann. Die der Anbindungsfläche zugewandte Fläche des Kühlkörpers, gegen welche die Anbindungsfläche gepresst wird, ist insbesondere bei durch ein Gussverfahren hergestellten Kühlkörpern aufgrund einer zur Entformung aus der Gießform notwendigen Entformungsschräge schräg ausgebildet.

Darüber hinaus kann bei einer Variante vorgesehen sein, dass in dem Abschnitt der Wandung, welcher dem Kühlkörper zugewandt ist bzw. an diesen im endmontierten Zustand angrenzt, Abstandshalter vorgesehen sind, welche beispielsweise integral durch den Anbindungsabschnitt ausgebildet werden und sich von dem Anbindungsabschnitt bzw. der Hartkomponente stegartig in den Wärmleitabschnitt bzw. in die Weichkomponente erstrecken und durch welche der minimale Abstand zwischen dem elektronischen Bauteil und dem Kühlkörper vorbestimmt werden. Kommt das elektronische Bauteil an den Abstandshaltern und die Abstandshalter an dem Kühlkörper zur Anlage, können diese sich nicht stärker aneinander annähern, so dass ein vorbestimmter Minimalabstand unabhängig von einer möglichen plastischen Verformung des Wärmeleitabschnitts nicht unterschritten werden kann.

Um die Vormontage zu vereinfachen ist ferner vorzugsweise vorgesehen, dass das Spannelement und das Federelement an dem Anbindungsabschnitt aufgenommen sind.

Besonders vorteilhaft ist hierbei eine Ausführung, bei welcher der Anbindungsabschnitt erste Rastelemente und zweite Rastelemente ausbildet, wobei die ersten Rastelemente das Spannelement und die zweiten Rasteiemente das Federelement an dem Anbindungsabschnitt halten. Dabei kann vorgesehen sein, dass das Spannelement und das Federelement beweglich aufgenommen sind und der Bereich, in welchem sie sich bewegen können, durch die ersten und zweiten Rastelemente begrenzt wird.

Dadurch ist es bei der Montage nicht notwendig, mehrere Elemente unabhängig voneinander zu greifen und an der Leiterplatte oder anderen Elementen zu befestigen. Vielmehr kann die Haltevorrichtung in ihrer Gesamtheit mit ihren miteinander verbundenen Komponenten zur Verfügung gestellt, gelagert, gegriffen und montiert werden. Obgleich sich Federelement und Spannelement im Rahmen dessen was die Rastelemente gestatten gegenüber dem Haltekörper bewegen können, sind diese dennoch unverlierbar miteinander verbunden, so dass die Haltevorrichtung zwar mehrkomponentig jedoch einteilig ausgebildet ist.

Um zu vermeiden, dass die Haltevorrichtung unzulässig gegenüber dem elektronischen Bauteil verrutscht oder sich dieses wieder aus dem Hohlraum des Haltekörpers schiebt, ist bei einer ebenfalls vorteilhaften Ausgestaltungsvariation vorgesehen, dass der Haltekörper in den Hohlraum ragende dritte Rastelemente ausbildet, welche ausgebildet sind, das in dem Hohlraum aufnehmbare elektronische Bauteil in dem Hohlraum zu fixieren. Hierzu kann das elektronische Bauteil Rastausnehmungen aufweisen. Alternativ können die dritten Rastelemente beispielsweise auch eine zu der Leiterplatte weisende Kante des elektronischen Bauteils umgreifen.

Ist vorgesehen, dass das elektronische Bauteil zunächst durch die Haltevorrichtung an der Leiterplatte fixiert und erst danach elektrisch mit der Leiterplatte verbunden wird, sieht eine Variante vorteilhafterweise zudem vor, dass der Haltekörper vierte Rastelemente aufweist, welche sich zu der Leiterplatte erstrecken, auf welcher das elektronische Bauteil montiert ist bzw. montierbar ist, und die Haltevorrichtung mit den vierten Rastelementen an der Leiterplatte fixierbar ist. Hierzu kann die Leiterplatte Rastöffnungen aufweisen, in welche die vierten Rastelemente eingreifen können, wobei diese Rastöffnungen auch länglich ausgebildet sein können, so dass sich die Haltevorrichtung mit dem darin aufgenommenen elektronischen Bauteil durch das Verspannen des Federelements zu dem Kühlkörper verschieben kann.

Bezüglich des Federelements sieht eine vorteilhafte Ausbildungsform vor, dass das Federelement eine Blattfeder ist, welche eine erste Kante und eine zu der ersten Kante in Längsrichtung der Blattfeder beabstandete zweite Kante aufweist, deren Abstand sich beim Spannen des Federelements durch das Spannelement vergrößert. Dies wird dadurch erreicht, dass die Höhe der Blattfeder durch das Spannen entgegen der Federkraft reduziert wird und die Enden bzw. Kanten der Blattfeder auseinander gespreizt werden. Hierbei ist die erste Kante ausgebildet, sich in dem gespannten Zustand an dem Gegenhalteelement abzustützen und die zweite Kante ausgebildet, in dem gespannten Zustand an dem Haltekörper und/oder an dem in dem Hohlraum des Haltekörpers aufnehmbaren Bauteil anzuliegen.

Eine vorteilhafte Variante sieht vor, dass das Spannelement eine Schraube ist und das Gegenhalteelement ein Gewinde aufweist, in welches die Schraube einschraubbar ist. Hierbei ist die Blattfeder vorzugsweise zwischen dem Schraubenkopf bzw. einer zu dem Schraubenkopf benachbarten Unterlegscheibe und dem Gegenhalteelement eingespannt, wobei die Schraube die Blattfeder durch eine Öffnung in der Blattfeder durchläuft, so dass durch ein Einschrauben der Schraube in das Gegenhalteelement der Abstand zwischen Schraubenkopf und Gegenhalteelement reduziert und die Blattfeder damit gestaucht bzw. deren Kanten auseinander gespreizt werden. Alternativ kann auch vorgesehen sein, dass ein das Gewinde aufweisender Körper Teil des Spannelements ist. Beispielsweise kann das Spannelement als eine Schraube und eine Mutter oder eine Schraube und eine Platte sein, welche ein Gewinde aufweist, so dass sich der Schraubenkopf und die Mutter oder Platte durch ein Verschrauben aufeinander zu bewegen und das Federelement zwischen sich stauchen bzw. spannen, so dass dieses sich aufspreizt und dadurch den Haltekörper verschiebt.

Ein weiterer Aspekt der Erfindung betrifft eine Leiterplatte mit einem elektronischen Bauteil und einer erfindungsgemäßen Haltevorrichtung.

Eine vorteilhafte Variante der Leiterplatte sieht vor, dass die Leiterplatte eine Öffnung aufweist, durch welche hindurch das Spannelement betätigbar und das Federelement durch das Spannelement spannbar ist. Ist das Spannelement eine Schraube, kann diese beispielsweise durch einen durch die Öffnung der Leiterplatte gesteckten Schraubendreher in das Gegenelement eingeschraubt werden.

Zudem sieht eine vorteilhafte Ausgestaltung der Leiterplatte vor, dass die Haltevorrichtung mit den vierten Rastelementen an der Leiterplatte befestigt ist und die Position des in dem Hohlraum der Haltevorrichtung aufgenommenen elektronischen Bauteils für die Montage des elektronischen Bauteils an der Leiterplatte vorbestimmt ist. Die Montage kann beispielsweise dadurch erfolgen, dass Kontaktstifte bzw. Pins des elektronischen Bauteils mit an der Leiterplatte vorgesehenen Kontaktflächen verlötet werden.

Ein weiterer Aspekt der Erfindung betrifft zudem ein Elektronikmodul bzw. Modul mit einem Gehäuse, einem Kühlkörper, einer erfindungsgemäßen Leiterplatte bzw. mit einer Leiterplatte und einer erfindungsgemäßen Haltevorrichtung.

Vorteilhaft ist insbesondere eine Ausbildungsform des Moduls, bei welcher das Gegenhalteelement integral von dem Gehäuse gebildet wird und die Haltevorrichtung über das Gegenhalteelement an dem Gehäuse befestigbar ist. Hierzu kann das Gehäuse bzw. das Gegenhalteelement beispielsweise ein Gewinde aufweisen, in welches ein als eine Schraube ausgebildetes Spannelement einschraubbar ist. Alternativ kann das Spannelement auch als ein Raststift vorgesehen sein, wobei das Gegenhalteelement bzw. das Gehäuse hierzu eine korrespondierende Rastöffnung vorsieht in welche der Raststift einsteckbar ist, so dass das Federelement durch den in die Rastöffnung eingerasteten Raststift gestaucht und der Haltekörper gegen den Kühlkörper verschoben bzw. gepresst ist.

Zudem sieht eine besonders vorteilhafte Variante des Moduls vor, dass das Gehäuse integral den Kühlkörper ausbildet.

Zu der Haltevorrichtung korrespondierend werden durch die Erfindung zudem zugehörige Montageverfahren vorgeschlagen.

Ein erstes vorteilhaftes Montageverfahren sieht vor, dass das elektronische Bauteil zunächst an der Leiterplatte montiert und elektrisch mit dieser verbunden wird. Anschließend oder bereits zuvor wird die Haltevorrichtung auf das elektronische Bauteil aufgesteckt, so dass das elektronische Bauteil in dem Hohlraum des Haltekörpers aufgenommen ist. Die Leiterplatte mit dem daran montierten elektronischen Bauteil und der Haltevorrichtung wird in ein Gehäuse oder an einem Kühlkörper angeordnet, jedoch noch nicht fixiert. Durch ein Spannen des Federelements wird der Haltekörper und die lose eingelegte Leiterplatte gegen den Kühlköper geschoben bzw. gegen eine der Anbindungsfläche des Haltekörpers gegenüberliegende Fläche des Kühlkörpers gepresst. Erst nachdem die Endposition durch das Spannen des Federelements bestimmt ist und das elektronische Bauteil thermisch mit dem Kühlkörper kontaktiert ist, wird die Leiterplatte an dem Gehäuse bzw. an dem Kühlkörper fixiert, was beispielsweise durch Verschrauben erfolgen kann.

Ein alternatives zweites, jedoch ebenfalls vorteilhaftes Montageverfahren sieht vor, dass das elektronische Bauteil in die Haltevorrichtung eingesteckt und durch die vierten Rastelemente der Haltevorrichtung an der Leiterplatte fixiert wird, so dass das elektronische Bauteil von der Haltevorrichtung an der Leiterplatte in einer vorgegebenen Position gehalten wird. Anschließend kann das elektronische Bauteil beispielsweise durch Löten elektrisch mit der Leiterplatte bzw. den dafür vorgesehenen Anschlussstellen der Leiterplatte kontaktiert werden. Für diese Variante des Montageverfahrens können die Haltevorrichtung und das elektronische Bauteil auch bereits als Baugruppe bereitgestellt werden.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt. Es zeigen:
- Fig. 1: die voneinander getrennten Komponenten der Haltevorrichtung;
- Fig. 2: den Haltekörper der Haltevorrichtung;
- Fig. 3: die Haltevorrichtung in einer perspektivischen Ansicht von schräg oben;
- Fig. 4: die Haltevorrichtung in einer perspektivischen Ansicht von schräg unten;
- Fig. 5: die Haltevorrichtung in einem vormontierten Zustand in einer Schnittansicht;
- Fig. 6: die Haltevorrichtung in einem endmontierten Zustand in einer Schnittansicht.

Die Figuren sind beispielhaft schematisch. Gleiche Bezugszeichen in den Figuren weisen auf gleiche funktionale und/oder strukturelle Merkmale hin.

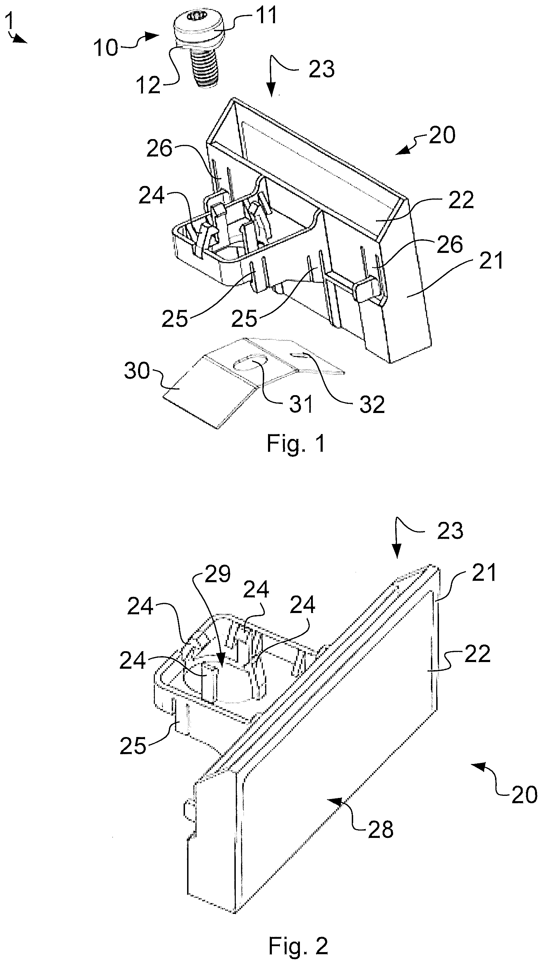

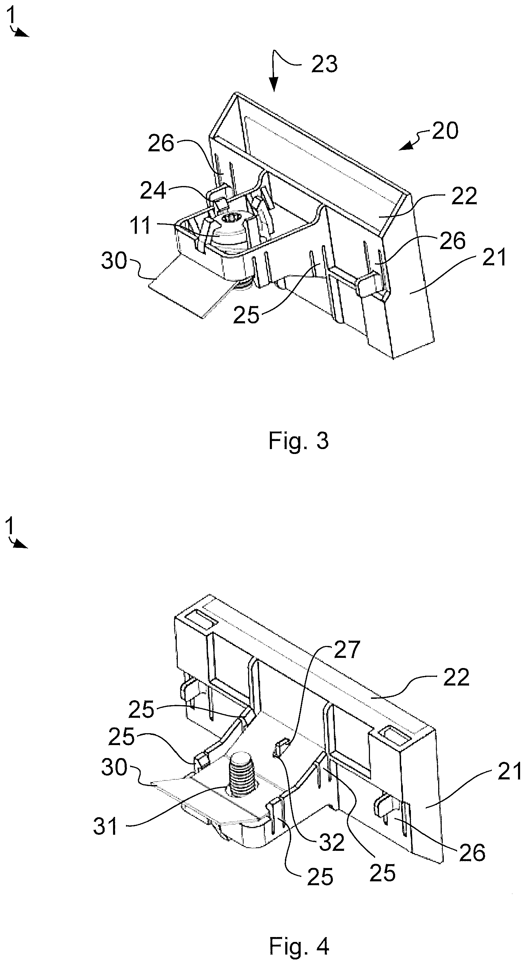

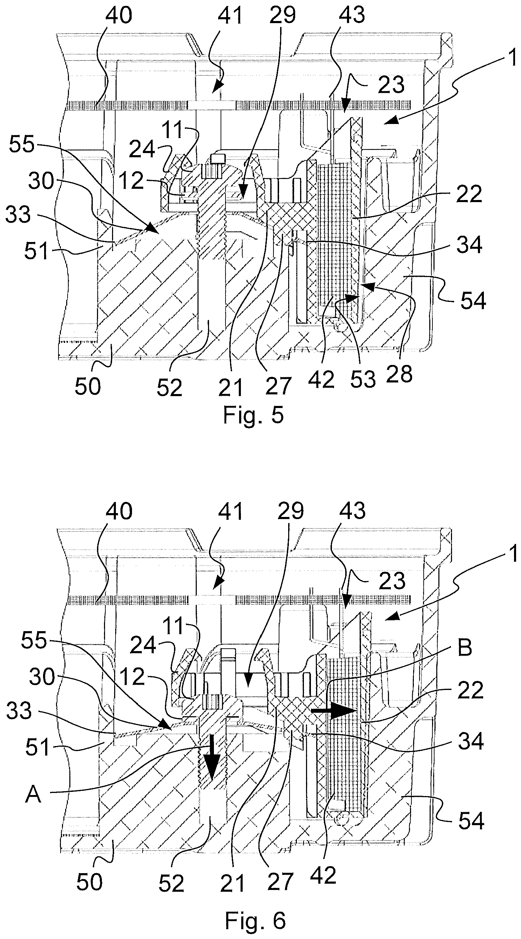

In Figur 1 ist die drei Komponenten aufweisende Haltevorrichtung 1 dargestellt, wobei die drei Komponenten, also der Haltekörper 20, das Spannelement 10 und das Federelement 30, voneinander getrennt sind. Der Haltekörper 20 allein ist zudem gedreht in Figur 2 abgebildet. Die Haltevorrichtung 1 mit seinen unverlierbar verbundenen Komponenten ist in den Figuren 3 und 4 abgebildet. Die Figuren 5 und 6 zeigen als Schnittansicht verschiedene Montagezustände der in den Figuren 1 bis 4 gezeigten Haltevorrichtung 1, so dass die nachfolgende Beschreibung im Wesentlichen für alle Figuren gilt.

Der Haltekörper 20 bildet an seinem Anbindungsabschnitt 21 vier erste Rastelemente 24 aus, welche ausgebildet sind den Schraubenkopf 11 des als Schraube ausgebildeten Spannelements 10 zu umgreifen und das Spannelement 10 dadurch unverlierbar an dem Haltekörper 20 aufzunehmen. Ferner bildet der Haltekörper 20 an seinem Anbindungsabschnitt 21 vier zweite Rastelemente 25 aus, welche ausgebildet sind, die gegenüberliegenden Seitenkanten des als Blattfeder ausgebildeten Federelements 30 zu umgreifen und das Federelement 30 dadurch ebenfalls unverlierbar mit dem Haltekörper 20 zu verbinden.

Der Hohlraum des Haltekörpers 20 wird sowohl durch den Anbindungsabschnitt 21 als auch den Wärmeleitabschnitt 22 des Haltekörpers 20 bestimmt, wobei der Hohlraum durch eine Öffnung 23 geöffnet ist, durch welche hindurch das elektronische Bauteil 42 in den Hohlraum einbringbar bzw. einsteckbar ist. Zur thermischen Kontaktierung des Bauteils 42 mit einem Kühlkörper 54, wie er beispielsweise in den Figuren 5 und 6 gezeigt ist, ist der Wärmeleitabschnitt 22 aus einem thermisch leitfähigem Material ausgebildet und liegt zu dem Hohlraum hin an dem darin aufgenommenen bzw. aufnehmbaren elektronischen Bauteil 42 bzw. einer Wärmeableitfläche des elektronischen Bauteils 42 an. Von dem Hohlraum weg weisend bildet der Wärmeleitabschnitt 22 eine Anbindungsfläche 28 aus, mit welcher er in einem endmontierten Zustand an dem Kühlkörper 54 anliegt bzw. anliegen kann.

Der Wärmeleitabschnitt 22 wird dabei, wie es insbesondere durch die Figuren 2 und 4 sichtbar ist, von dem Anbindungsabschnitt 21 rahmenförmig umlaufen bzw. umfasst, wobei sich der Wärmeleitabschnitt 22 über zwei Wandungsabschnitt erstreckt. Der Anbindungsabschnitt 21 ist vorzugsweise aus einem Thermoplast gebildet und bleibt bei den bei einem bestimmungsgemäßen Gebrauch herrschenden Temperaturen fest, so dass der Anbindungsabschnitt 21 als Hartkomponente bezeichnet werden kann, welche sowohl die weiteren Komponenten der Haltevorrichtung 1 als auch den Wärmeleitabschnitt 22 hält. Der Wärmeleitabschnitt 22 ist ferner aus einem thermoplastischen Elastomer gebildet, welches sich unter Temperatureinfluss plastisch verformen lässt, so dass sich der Wärmeleitabschnitt 22 unter den bei dem bestimmungsgemäßen Gebrauch herrschenden Temperaturen sowohl bündig an den Kühlkörper 54 als auch an das elektronische Bauteil 42 anschmiegt.

Um das elektronische Bauteil 42 in dem Hohlraum zu fixieren, sind zudem zweit zueinander beabstandete dritte Rastelemente 26 vorgesehen, welche sich mit einer Rastnase in den Hohlraum erstrecken und jeweils ausgebildet sind, mit einer in dem elektronischen Bauteil 42 vorgesehenen Rastausnehmung zu verrasten. Die sich von dem Hohlraum weg erstreckenden Vorsprünge der Rastelemente 26 sind jeweils Betätigungselemente, welche durch ein Werkzeug oder auch händisch betätigbar sind, um die Rastnasen der Rastelemente 26 aus der Verrastung mit dem Bauteil 42 zu lösen und das Bauteil 42 wieder leichter aus dem Hohlraum entfernen zu können.

Insbesondere in Figur 4, welche die Haltevorrichtung 1 aus einer, bezogen auf die Darstellung der Haltevorrichtung 1 in den Figuren 1 bis 3, unteren Ansicht zeigt, ist die Verbindung des Federelements 30 mit dem Haltekörper 20 zu erkennen. Das Federelement 30 wird von insgesamt vier zweiten Rastelementen 25 gehalten, welche sich paarweise gegenüberliegen, wobei in dem Federelement 30 eine Ausnehmung 32 vorgesehen ist, durch welche hindurch ein von dem Anbindungsabschnitt 21 des Haltekörpers 20 ausgebildeter Führungssteg 27 verläuft. Durch den Führungssteg 27 wird das Federelement 30 bei einer Stauchung bzw. Spannung durch das Spannelement 10 geführt, so dass das Federelement 30 nicht unzulässig ausweichen kann und verhindert wird, dass keine oder eine zu geringe Kraft auf den Haltekörper 20 ausgeübt wird. Vorliegend ist das Spannelement 10 als Schraube ausgeführt, welche das Federelement 30 mit einem Abschnitt durchläuft, wofür in dem Federelement 30 eine Öffnung 31 vorgesehen ist.

Die Schnittdarstellung der Figur 5 zeigt einen Teil eines Gehäuses 50, welches integral sowohl das Gegenhalteelement 51 als auch den Kühlkörper 54 ausbildet, wobei in dem Gehäuse 50 eine Leiterplatte 40 angeordnet ist. Durch das Anordnen der Leiterplatte 40 in dem Gehäuse ist der Anbindungsbereich des auf der Leiterplatte 40 vorgesehenen elektronischen Bauteils 42 an den Kühlkörper 54 verdeckt. Um das Bauteil 42 jedoch prozesssicher thermisch mit dem Kühlkörper 54 verbinden zu können, ist auf das Bauteil 42 eine Haltevorrichtung 1 aufgesteckt. Die Leiterplatte 40 wird mit seinem elektronischen Bauteil 42 und der darauf aufgesteckten Haltevorrichtung 1 in das Gehäuse eingelegt. Anschließend kann die Leiterplatte 40 an nicht gezeigten Anbindungspunkten an dem Gehäuse 50 fixiert werden. Durch die Öffnung 41 in der Leiterplatte 40 wird das als Schraube ausgebildete Spannelement 10 mit Hilfe eines Werkzeugs bzw. mit Hilfe eines Schraubendrehers, welcher in die Aufnahme des Schraubenkopfs 11 eingesteckt wird, gedreht und dadurch in ein Gewinde 52 eingeschraubt, welches in dem Gegenhalteelement 51 ausgebildet ist.

Dabei wird zunächst der in Figur 5 gezeigte erste Zustand erreicht, bei welchem das Spannelement 10 und dadurch die gesamte Haltevorrichtung 1 bereits mit dem Gegenhalteelement 51 und integral mit dem Gehäuse 50 verbunden, das Federelement 30 jedoch noch nicht gespannt und der Wärmeleitabschnitt 22 bzw. dessen Anbindungsfläche 28 noch nicht mit dem Kühlkörper 54 bzw. dessen Anbindungsfläche 53 kontaktiert ist.

Bei der in den Figuren 1 bis 6 gezeigten Ausführungsform ist vorgesehen, dass das als Schraube ausgeführte Spannelement 10 dadurch an dem Haltekörper 20 gehalten wird, dass eine Beweglichkeit des Schraubenkopfs 11 bezogen auf die Darstellung der Figuren 5 und 6 nach oben durch die ersten Rastelemente 24 und nach unten durch das Federelement 30 begrenzt wird, dessen Beweglichkeit wiederum nach oben durch den Anbindungsabschnitt 21 und nach unten durch die zweiten Rastelemente 25 begrenzt wird. Eine Beweglichkeit des Spannelements 10 und des Federelements 30 orthogonal dazu bzw. zu den Seiten wird jeweils durch die jeweiligen Rastelemente 24, 25 bzw. durch das Anbindungselement und bezüglich des Federelements 30 insbesondere durch den Führungssteg 27 begrenzt. Das Spannelement 10 und das Federelement 30 können sich bei der Montage zumindest teilweise wieder von dem Haltekörper 20 bzw. aus der Verrastung mit den jeweiligen Rastelementen 24, 25 lösen, wobei diese geführt durch den Führungssteg 27 dennoch in einer vorbestimmten Position bleiben und den Haltekörper 20 gegen den Kühlkörper 54 pressen.

In der Schnittansicht der Figuren 5 und 6 ist zudem deutlich gezeigt, dass der an den Kühlkörper 54 angrenzende bzw. zu diesem benachbarte Wandungsabschnitt eine in der Darstellung nach unten hin zulaufende Keilform aufweist, durch welche ein Winkelversatz zwischen der im Wesentlichen vertikalen Fläche des elektronischen Bauteils 42, welche dem Kühlkörper 54 zugewandt ist, und der Anbindungsfläche 53 des Kühlkörpers 54, welche als Entformungsschräge schräg ausgebildet ist, ausgleicht.

Ausgehend von dem ersten, in Figur 5 dargestellten Zustand, wird das Spannelement 10 mit einem durch die Öffnung 41 der Leiterplatte 40 reichendem Werkzeug in Richtung A weiter in den Gegenhalter 51 bzw. in dessen Gewinde 52 eingeschraubt, wodurch sich der Schraubenkopf 11 und die an der Schraube zur Verteilung der Kraft auf das Federelement 30 vorgesehene Unterlegscheibe 12 durch die in dem Anbindungsabschnitt 21 ausgebildete Öffnung 29 verschieben und gegen das Federelement 30 gepresst werden. Wird die Schraube weiter in Richtung A in das Gewinde 52 eingeschraubt, nähert sich der Schraubenkopf 11 bzw. die Unterlegscheibe 12 der Fläche 55 des Gegenhalteelements 51 bzw. des Gehäuses 50 an, so dass das Federelement 30 zwischen der Unterlegscheibe 12 und der Fläche 55 gestaucht wird und die erste Kante 33 und die gegenüberliegende Kante 34 des Federelements 30 dadurch auseinander gespreizt werden. Die erste Kante 33 kommt dabei an dem Gegenhalteelement 51 zur Anlage und stützt sich an diesem ab. Die zweite Kante 34 kommt an dem Haltekörper 20 und bei dem gezeigten Ausführungsbeispiel an einem an den Hohlraum bzw. an das elektronische Bauteil 42 angrenzenden Wandungsabschnitt zur Anlage, so dass der Haltekörper 20 durch das Auseinanderspreizen der ersten und zweiten Kante 33, 34 gegenüber dem Gegenhalteelement 51 bzw. gegenüber dem Gehäuse 50 in Richtung B verschoben wird. Durch die Verschiebung des Haltekörpers 20 in Richtung B nähert sich die Anbindungsfläche 28 des Wärmeleitabschnitts 22 der Anbindungsfläche 53 des Kühlkörpers 54 an und kommt schließlich an dieser zur Anlage, so dass die Anbindungsflächen 28, 53 aufeinander gepresst werden, was dem in Figur 6 gezeigten, zweiten Zustand bzw. bezüglich des Haltelements 1 endmontierten Zustand entspricht.

Dadurch, dass das Federelement 30 weiterhin eine Kraft bzw. eine Federkraft auf den Haltekörper 20 ausübt, wird der Haltekörper 20 im Falle einer plastischen Verformung des Wärmeleitabschnitts 22 weiter in Richtung des Kühlkörpers 54 gepresst.

In dem gezeigten Ausführungsbeispiel werden die Kontaktstifte 43 des elektronischen Bauteils 42 zusammen mit dem elektronischen Bauteil und der Haltevorrichtung 1 in Richtung B verschoben. Um eine solche Verschiebung der Kontaktstifte 43 in der Leiterplatte 40 zu ermöglichen, können in dieser beispielsweise längliche Ausnehmungen für die Durchsteckmontage des Bauteils 42 vorgesehen sein, wobei eine Verschiebung auch nur im Rahmen des Spiels der Ausnehmungen gegenüber den Kontaktstiften 43 möglich sein kann. Ein Verlöten bzw. ein elektrisches Kontaktierten der Kontaktstifte 43 erfolgt dann erst nachdem das Bauteil 42 thermisch mit dem Kühlkörper 54 verbunden ist.

## Patentansprüche

1. Haltevorrichtung (1) zur thermischen Kontaktierung eines auf einer Leiterplatte (40) montierten elektronischen Bauteils (42) mit einem Kühlkörper (54), wobei
die Haltevorrichtung (1) einen Haltekörper (20), ein Federelement (30) und ein Spannelement (10) aufweist, wobei
der Haltekörper (20) einen zu dem elektronischen Bauteil (42) korrespondierenden Hohlraum zur Aufnahme des elektronischen Bauteils (42) ausbildet und einen Anbindungsabschnitt (21) sowie einen an den Hohlraum angrenzenden und thermisch leitenden Wärmeleitabschnitt (22) mit einer von dem Hohlraum abgewandten thermischen Anbindungsfläche (28) aufweist, wobei
das Spannelement (10) ausgebildet ist, das Federelement (30) zu spannen, wobei
das Federelement (30) ausgebildet ist, sich in einem gespannten Zustand an einem Gegenhalteelement (51) abzustützen und eine Kraft auf den Haltekörper (20) und/oder das in dem Hohlraum des Haltekörpers (20) aufnehmbare Bauteil (42) auszuüben und den Haltekörper (20) mit der Anbindungsfläche (28) an den Kühlkörper (54) zu verschieben und/oder gegen den Kühlkörper (54) zu pressen, **dadurch gekennzeichnet, dass**
der Anbindungsabschnitt (21) formfest ausgebildet ist und der Wärmeleitabschnitt (22) aus einem wärmeleitfähigen thermoplastischen Elastomer gebildet ist.

2. Haltevorrichtung nach Anspruch 1, wobei
der Haltekörper (20) einstückig ausgebildet ist.

3. Haltevorrichtung nach einem der vorhergehenden Ansprüche, wobei
eine den Hohlraum umgebende Wandung von dem Anbindungsabschnitt (21) und dem Wärmeleitabschnitt (22) gebildet wird.

4. Haltevorrichtung nach einem der vorhergehenden Ansprüche, wobei
der Anbindungsabschnitt (21) den Wärmeleitabschnitt (22) rahmenförmig umschließt.

5. Haltevorrichtung nach einem der vorhergehenden Ansprüche, wobei
das Spannelement (10) und das Federelement (30) an dem Anbindungsabschnitt (21) aufgenommen sind.

6. Haltevorrichtung nach Anspruch 5, wobei
der Anbindungsabschnitt (21) erste Rastelemente (24) ausbildet und zweite Rastelemente (25) ausbildet, wobei
die ersten Rastelemente (24) das Spannelement (10) und die zweiten Rastelemente (25) das Federelement (30) an dem Anbindungsabschnitt (21) halten.

7. Haltevorrichtung nach einem der vorhergehenden Ansprüche, wobei
der Haltekörper (20) in den Hohlraum ragende dritte Rastelemente (26) ausbildet, welche ausgebildet sind, das in dem Hohlraum aufnehmbare elektronische Bauteil (42) in dem Hohlraum zu fixieren.

8. Haltevorrichtung nach einem der vorhergehenden Ansprüche, wobei
der Haltekörper (20) eine mit dem Hohlraum verbundene Öffnung (23) aufweist, durch welche das elektronische Bauteil (42) in den Hohlraum einsteckbar ist, wobei
die Öffnung (23) der Leiterplatte (40), auf welcher das elektronische Bauteil (42) montiert ist, zugewandt ist.

9. Haltevorrichtung nach einem der vorhergehenden Ansprüche, wobei
der Haltekörper (20) vierte Rastelemente aufweist, welche sich zu der Leiterplatte (40) erstrecken, auf welcher das elektronische Bauteil (42) montiert ist, und die Haltevorrichtung (20) mit den vierten Rastelementen an der Leiterplatte (40) fixierbar ist.

10. Haltevorrichtung nach einem der vorhergehenden Ansprüche, wobei
das Federelement (30) eine Blattfeder ist, welche eine erste Kante (33) und eine zu der ersten Kante (33) in Längsrichtung der Blattfeder beabstandete zweite Kante (34) aufweist, deren Abstand sich beim Spannen des Federelements (30) durch das Spannelement (10) vergrößert, wobei
die erste Kante (33) ausgebildet ist, sich in dem gespannten Zustand an dem Gegenhalteelement (51) abzustützen und die zweite Kante (34) ausgebildet ist, in dem gespannten Zustand an dem Haltekörper (20) und/oder an dem in dem Hohlraum des Haltekörpers (20) aufnehmbaren Bauteil (42) anzuliegen.

11. Haltevorrichtung nach einem der vorhergehenden Ansprüche, wobei
das Spannelement (10) eine Schraube ist und das Gegenhalteelement (51) ein Gewinde (52) aufweist, in welches die Schraube einschraubbar ist.

12. Leiterplatte (40) mit einem elektronischen Bauteil (42) und einer Haltevorrichtung (1) gemäß einem der vorhergehenden Ansprüche.

13. Leiterplatte nach dem vorhergehenden Anspruch, wobei
die Leiterplatte (40) eine Öffnung (41) aufweist, durch welche hindurch das Spannelement (10) betätigbar und das Federelement (30) durch das Spannelement (10) spannbar ist.

14. Leiterplatte nach einem der beiden vorhergehenden Ansprüche und Anspruch 10, wobei
die Haltevorrichtung (1) mit den vierten Rastelementen an der Leiterplatte (40) befestigt ist und die Position des in dem Hohlraum der Haltevorrichtung (1) aufgenommenen elektronischen Bauteils (42) für die Montage des elektronischen Bauteils (42) an der Leiterplatte (40) vorbestimmt ist.

15. Modul mit einem Gehäuse (50), einem Kühlkörper (54), einer Leiterplatte (40) nach einem der Ansprüche 12 bis 14.

16. Modul nach dem vorhergehenden Anspruch, wobei
das Gegenhalteelement (51) integral von dem Gehäuse (50) gebildet wird und die Haltevorrichtung (1) über das Gegenhalteelement (51) an dem Gehäuse (50) befestigbar ist.

17. Modul nach einem der beiden vorhergehenden Ansprüche, wobei das Gehäuse (50) integral den Kühlkörper (54) ausbildet.

## Claims

1. A holder (1) for thermally contacting an electronic component (42) mounted on a circuit board (40) with a cooling body (54) comprising:
the holder (1) includes a holding body (20), a spring member (30), and a tensioning member (10);
the holding body (20) forms a cavity corresponding to the electronic component (42) to receive the electronic component (42) and comprises a connecting section (21), a thermally conductive heat conductive section (22), adjacent to the cavity, and a thermal connecting surface (28), facing away from the cavity;
the tensioning member (10) is configured to tension the spring member (30); and
the spring member (30) configured to support itself in a tensioned state on a counter-holding member (51) to apply a force onto the holding body (20) and/or onto the component (42) receivable in the cavity of the holding body (20), the spring member (30) moves the connecting surface (28) of the holding body (20) to the cooling body (54) and/or presses it against the cooling body (54), **characterized in that**
the connecting section (21) is dimensionally stable and the heat conductive section (22) is formed of a thermoplastic elastomer.

2. The holder according to claim 1, wherein the holding body (20) is formed in one piece.

3. The holder according to one of the preceding claims, wherein a wall surrounding the cavity is formed by the connecting section (21) and the heat conductive section (22).

4. The holder according to one of the preceding claims, wherein the connecting section (21) encloses the heat conductive section (22) in a frame-like manner.

5. The holder according to one of the preceding claims, wherein the tensioning member (10) and the spring member (30) are received at the connecting section (21).

6. The holder according to Claim 5, wherein
the connecting section (21) includes first latching members (24) and second latching members (25),
the first latching members (24) hold the tensioning member (10) and the second latching members (25) hold the spring member (30) on the connecting section (21).

7. The holder according to one of the preceding claims, wherein the holding body (20) includes third latching members (26) that project into the cavity and are configured to secure the electronic component (42), that can be received in the cavity, in the cavity.

8. The holder according to one of the preceding claims, wherein
the holding body (20) has an opening (23) connected to the cavity and the electronic component (42) can be inserted into the cavity through the opening (23); and
the opening (23) is faces the circuit board (40) where the electronic component (42) is mounted.

9. The holder according to one of the preceding claims, wherein the holding body (20) includes fourth latching members that extend to the circuit board (40) where the electronic component (42) is mounted, and the holder (20) can be secured to the circuit board (40) using the fourth latching members.

10. The holder according to one of the preceding claims, wherein
the spring member (30) is a leaf spring with a first edge (33) and a second edge (34) spaced apart from the first edge (33) in the longitudinal direction of the leaf spring, the spacing increases when the spring member (30) is tensioned by the tensioning member (10); and
the first edge (33) is configured to support itself on the counter-holding member (51) in the tensioned state, and the second edge (34) is configured to rest against the holding body (20) and/or the component (42) receivable in the cavity of the holding body (20) in the tensioned state.

11. The holder according to one of the preceding claims, wherein the tensioning member (10) is a screw and the counter-holding member (51) has a thread (52) to receive the screw.

12. A circuit board (40) with an electronic component (42) and a holder (1) according to one of the preceding claims.

13. The circuit board according to the preceding claim, wherein the circuit board (40) has an opening (41) through which the tensioning member (10) can be operated and the spring member (30) can be tensioned by the tensioning member (10).

14. The circuit board according to one of the two preceding claims and claim 10, wherein
the holder (1) is fastened to the circuit board (40) with the fourth latching members, and the position of the electronic component (42) received in the cavity of the holder (1) for mounting the electronic component (42) to the circuit board (40) is predetermined.

15. A module including a housing (50), a cooling body (54), a circuit board (40) according to one of the claims 12 to 14.

16. The module according to the preceding claim,
wherein the counter-holding member (51) is integrally formed by the housing (50) and the holder (1) can be secured to the housing (50) by the counter-holding member (51).

17. The module according to one of the two preceding claims,
wherein the housing (50) integrally forms the cooling body (54).

## Revendications

1. Dispositif de maintien (1) pour la mise en contact thermique d'un composant électronique (42) monté sur une carte de circuits imprimés (40) et comprenant un dissipateur thermique (54), dans lequel
le dispositif de maintien (1) présente un corps de maintien (20), un élément faisant ressort (30) et un élément de serrage (10), dans lequel
le corps de maintien (20) réalise une cavité correspondant au composant électronique (42) et servant à recevoir le composant électronique (42), et présente une partie de raccordement (21) ainsi qu'une partie de conduction de chaleur (22) thermoconductrice et adjacente à la cavité, pourvue d'une surface de raccordement thermique (28) détournée de la cavité, dans lequel
l'élément de serrage (10) est réalisé pour serrer l'élément faisant ressort (30), dans lequel
l'élément faisant ressort (30) est réalisé pour prendre appui dans un état serré sur un élément de maintien antagoniste (51) et pour exercer une force sur le corps de maintien (20) et/ou le composant (42) pouvant être reçu dans la cavité du corps de maintien (20), et pour déplacer le corps de maintien (20) pourvu de la surface de raccordement (28) vers le dissipateur thermique (54) et/ou pour le presser contre le dissipateur thermique (54),
**caractérisé en ce que** la partie de raccordement (21) est réalisée de manière indéformable, et la partie de conduction de chaleur (22) est formée à partir d'un élastomère thermoplastique thermoconducteur.

2. Dispositif de maintien selon la revendication 1, dans lequel le corps de maintien (20) est réalisé d'un seul tenant.

3. Dispositif de maintien selon l'une quelconque des revendications précédentes, dans lequel une paroi entourant la cavité est formée par la partie de raccordement (21) et la partie de conduction de chaleur (22).

4. Dispositif de maintien selon l'une quelconque des revendications précédentes, dans lequel la partie de raccordement (21) entoure la partie de conduction de chaleur (22) à la manière d'un cadre.

5. Dispositif de maintien selon l'une quelconque des revendications précédentes, dans lequel l'élément de serrage (10) et l'élément faisant ressort (30) sont reçus au niveau de la partie de raccordement (21).

6. Dispositif de maintien selon la revendication 5, dans lequel
la partie de raccordement (21) réalise des premiers éléments d'arrêt (24) et des deuxièmes éléments d'arrêt (25), dans lequel
les premiers éléments d'arrêt (24) maintiennent l'élément de serrage (10) et les deuxièmes éléments d'arrêt (25) maintiennent l'élément faisant ressort (30) au niveau de la partie de raccordement (21).

7. Dispositif de maintien selon l'une quelconque des revendications précédentes, dans lequel le corps de maintien (20) réalise des troisièmes éléments d'arrêt (26) faisant saillie dans la cavité, qui sont réalisés pour fixer dans la cavité le composant électronique (42) pouvant être reçu dans la cavité.

8. Dispositif de maintien selon l'une quelconque des revendications précédentes, dans lequel
le corps de maintien (20) présente une ouverture (23) relié à la cavité, à travers laquelle le composant électronique (42) peut être enfiché dans la cavité, dans lequel
l'ouverture (23) est tournée vers la carte de circuits imprimés (40) sur laquelle est monté le composant électronique (42).

9. Dispositif de maintien selon l'une quelconque des revendications précédentes, dans lequel le corps de maintien (20) présente des quatrièmes éléments d'arrêt qui s'étendent vers la carte de circuits imprimés (40) sur laquelle est monté le composant électronique (42), et le dispositif de maintien (20) peut être fixé à la carte de circuits imprimés (40) à l'aide des quatrièmes éléments d'arrêt.

10. Dispositif de maintien selon l'une quelconque des revendications précédentes, dans lequel
l'élément faisant ressort (30) est un ressort à lames qui présente un premier bord (33) et un deuxième bord (34) espacé par rapport au premier bord (33) dans la direction longitudinale du ressort à lames, dont l'espacement augmente lors du serrage de l'élément faisant ressort (30) par l'élément de serrage (10), dans lequel
le premier bord (33) est réalisé pour prendre appui à l'état serré sur l'élément de maintien antagoniste (51), et le deuxième bord (34) est réalisé à l'état serré pour être adjacent au corps de maintien (20) et/ou au composant (42) pouvant être reçu dans la cavité du corps de maintien (20).

11. Dispositif de maintien selon l'une quelconque des revendications précédentes, dans lequel l'élément de serrage (10) est une vis et l'élément de maintien antagoniste (51) présente un taraudage (52) dans lequel la vis peut être vissée.

12. Carte de circuits imprimés (40) comprenant un composant électronique (42) et un dispositif de maintien (1) selon l'une quelconque des revendications précédentes.

13. Carte de circuits imprimés selon la revendication précédente, dans laquelle la carte de circuits imprimés (40) présente une ouverture (41) à travers laquelle l'élément de serrage (10) peut être actionné et l'élément faisant ressort (30) peut être serré par l'élément de serrage (10).

14. Carte de circuits imprimés selon l'une des deux revendications précédentes et la revendication 10, dans lequel le dispositif de maintien (1) est fixé à la carte de circuits imprimés (40) à l'aide des quatrièmes éléments d'arrêt, et la position du composant électronique (42) reçu dans la cavité du dispositif de maintien (1) est prédéterminée pour le montage du composant électronique (42) sur la carte de circuits imprimés (40).

15. Module comprenant un boîtier (50), un dissipateur thermique (54) et une carte de circuits imprimés (40) selon l'une quelconque des revendications 12 à 14.

16. Module selon la revendication précédente, dans lequel l'élément de maintien antagoniste (51) est formé d'un seul tenant avec le boîtier (50), et le dispositif de maintien (1) peut être fixé au boîtier (50) par l'intermédiaire de l'élément de maintien antagoniste (51).

17. Module selon l'une des deux revendications précédentes, dans lequel le boîtier (50) réalise le dissipateur thermique (54) d'un seul tenant.
